(19) Europäisches Patentamt
European Patent Office
Office européen des brevets

(11) **EP 2 808 690 A1**

(12) **EUROPEAN PATENT APPLICATION**

(43) Date of publication:
**03.12.2014 Bulletin 2014/49**

(51) Int Cl.:
***G01R 31/36*** *(2006.01)*

(21) Application number: **14170121.9**

(22) Date of filing: **27.05.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **27.05.2013 KR 20130059841**

(71) Applicant: **Samsung SDI Co., Ltd.
Yongin-si, Gyeonggi-do (KR)**

(72) Inventors:
• **Lee, Soo-Jin
Gyeonggi-do (KR)**
• **Cho, Young-Shin
Gyeonggi-do (KR)**
• **Shim, Young-Woo
Gyeonggi-do (KR)**

(74) Representative: **Mounteney, Simon James
Marks & Clerk LLP
90 Long Acre
London
WC2E 9RA (GB)**

(54) **Battery management system and method of driving the same**

(57) A battery management system (BMS) and a method of driving the same are disclosed. In one aspect, the BMS includes a first state of charge (SOC) estimator configured to estimate an SOC of a battery using at least one of i) a charge and discharge current of the battery, ii) a voltage of the battery and iii) a temperature of the battery. The BMS also includes a residual capacity estimator, when the estimated SOC is substantially equal to or less than the reference SOC, configured to estimate a current residual capacity using at least one of i) a reference residual capacity calculated from a reference SOC, ii) the measured battery voltage, iii) a first reference voltage, and iv) a second reference voltage. The BMS further includes a second SOC estimator configured to estimate a current SOC based at least in part on the current residual capacity.

FIG .3

**Description**

CROSS-REFERENCE TO RELATED APPLICATIONS

BACKGROUND

Field

The present invention generally relates to a battery management system and a method of driving the same, and more particularly, to a battery management system configured to precisely estimate a residual capacity of a battery and a method of driving the same.

Description of the Related Technology

There have been many recent developments in secondary or rechargeable batteries that have high energy density and use a non-aqueous electrolyte solution. A plurality of high output secondary batteries can be serially connected to form a large capacity secondary battery (hereinafter, referred to as a battery). The large capacity secondary battery may be used for a high power apparatus such as a motor for an electric vehicle.

Generally, the charge and discharge operation of the secondary batteries is controlled such that each battery can be maintained in a proper operation state. For this purpose, a battery management system (BMS) can be configured to measure voltages of the secondary batteries and a voltage and a current of the battery. The BMS is also configured to manage the charge and discharge operation of the secondary batteries.

A typical battery management system estimates a state of charge (hereinafter, referred to as SOC) through an open circuit voltage (OCV) of a secondary battery and current integration (addition). However, in order to measure the OCV, a user generally needs to stand by for a certain amount of time until the measurement is complete. In addition, repeated charge and discharge cycles can cause errors in current summation. This can reduce the accuracy of measurement of the SOC.

There has been a method of previously determining the relationship between factors such as the OCV, a discharge voltage, a discharge current, internal resistance, and a temperature and the SOC and detecting at least two factors to estimate the SOC corresponding to the detected factors.

In the above method, due to an error in current addition at the end of discharge or a change in a current or a temperature during discharge, the SOC might not be correctly estimated. In order to solve the problem, when a cell voltage reaches a previously set value, the SOC is generally compensated for so that the SOC is rapidly increased or reduced at a compensation point in time.

SUMMARY OF CERTAIN INVENTIVE ASPECTS

is the present invention sets out to provide a battery management system (BMS) capable of correctly estimating a state of charge (SOC) at the end of discharge of a battery and a method of driving the same.

Accordingly, the invention provides a BMS which includes a sensing unit configured to measure and output charge and discharge current of a battery, a voltage of a battery, and a temperature of a battery and a main controller unit (MCU) configured to estimate a state of charge (SOC) of the battery. The MCU can include a first SOC estimating unit configured to estimate an SOC of a battery using at least one of the charge and discharge current, the battery voltage, and the battery temperature input from the sensing unit, a residual capacity estimating unit configured to estimate a current residual capacity using at least one of a reference residual capacity calculated using a reference SOC, the measured current battery voltage, a first reference voltage, and a second reference voltage when the estimated SOC is substantially equal to or less than the reference SOC, and a second SOC estimating unit configured to estimate a current SOC using the current residual capacity.

The reference SOC may be between about 5% and about 8%.

The first reference voltage may mean a discharge stop voltage of the battery and the second reference voltage may mean a voltage of the battery measured at a point in time when the estimated SOC and the reference SOC are the same.

The residual capacity estimating unit may estimate a current first residual capacity proportional to a value obtained by dividing a difference between the current battery voltage and the first reference voltage by a first proportional constant. The first proportional constant may be proportional to a value obtained by dividing a difference between the second reference voltage and the first reference voltage by the reference residual capacity.

The residual capacity estimating unit may estimate a current second residual capacity proportional to an exponential function of a value obtained by dividing a difference between the current battery voltage and the first reference voltage by a second proportional constant. The second proportional constant may be proportional to a value obtained by dividing a difference between the second reference voltage and the first reference voltage by a natural logarithm of the reference residual capacity.

The residual capacity estimating unit may estimate a current third residual capacity proportional to an exponential function of a value obtained by dividing a difference between the current battery voltage and the first reference voltage by a third proportional constant. The third proportional constant may be proportional to a value obtained by dividing a difference between the second reference voltage and the first reference voltage by a natural logarithm of the reference residual capacity.

The second SOC estimating unit may estimate the current SOC using the first residual capacity when the battery temperature is less than 0°C.

The second SOC estimating unit may estimate the current SOC using the third residual capacity when the battery temperature is no less than 0°C.

When the battery voltage is substantially equal to or less than a reference voltage, the residual capacity calculating unit may set up the estimated SOC when the measured battery voltage is the same as the reference voltage as the reference SOC and may estimate the current residual capacity.

The reference voltage may be determined using a previously set voltage, current charge and discharge current, and internal resistance of the battery.

Another aspect is a method of driving a BMS, including estimating an SOC of a battery using at least one of charge and discharge current of a battery, a voltage of a battery, and a temperature of a battery, estimating a current residual capacity using at least one of a reference residual capacity calculated using a reference SOC, the measured current battery voltage, a first reference voltage, and a second reference voltage when the estimated SOC is substantially equal to or less than the reference SOC, and estimating a current SOC using the current residual capacity.

According to at least one of the disclosed embodiments, it is possible to correctly estimate the SOC without rapid reduction in the SOC at the end of discharge of the battery.

At least some of the above and other features of the invention are set out in the claims.

BRIEF DESCRIPTION OF THE DRAWINGS

Several embodiments of the invention will now be described more fully hereinafter with reference to the accompanying drawings. However, the invention may be embodied in different forms and should not be construed as limited to the embodiments set forth herein. Rather, these embodiments are provided so that this disclosure will be thorough and will convey the scope of the invention to those skilled in the art.

In the drawing figures, dimensions may be exaggerated for clarity. It will be understood that when an element is referred to as being "between" two elements, it can be the only element between the two elements, or one or more intervening elements may also be present. Like reference numerals refer to like elements throughout.

FIG. 1 shows a battery according to one embodiment of the invention.

FIG. 2 is a view illustrating an example of a case in which a state of charge (SOC) is rapidly reduced by compensation during estimating the SOC by current integration.

FIG. 3 is a block diagram schematically illustrating a battery management system (BMS) according to an embodiment of the invention.

FIG. 4 is a graph illustrating an actual battery voltage and a result of estimating an SOC according to some embodiments when a temperature around a battery is substantially equal to or less than about 0°C.

FIG. 5 is a graph illustrating an actual battery voltage and a result of estimating a residual capacity when a temperature around a battery is less than about 0°C according to one embodiment of the invention.

FIG. 6 is a flowchart illustrating a method of driving a BMS according to one embodiment of the invention.

DETAILED DESCRIPTION

Hereinafter, certain embodiments according to the invention will be described with reference to the accompanying drawings. Here, when a first element is described as being coupled to a second element, the first element may be not only directly coupled to the second element but may also be indirectly coupled to the second element via a third element. Like reference numerals refer to like elements throughout.

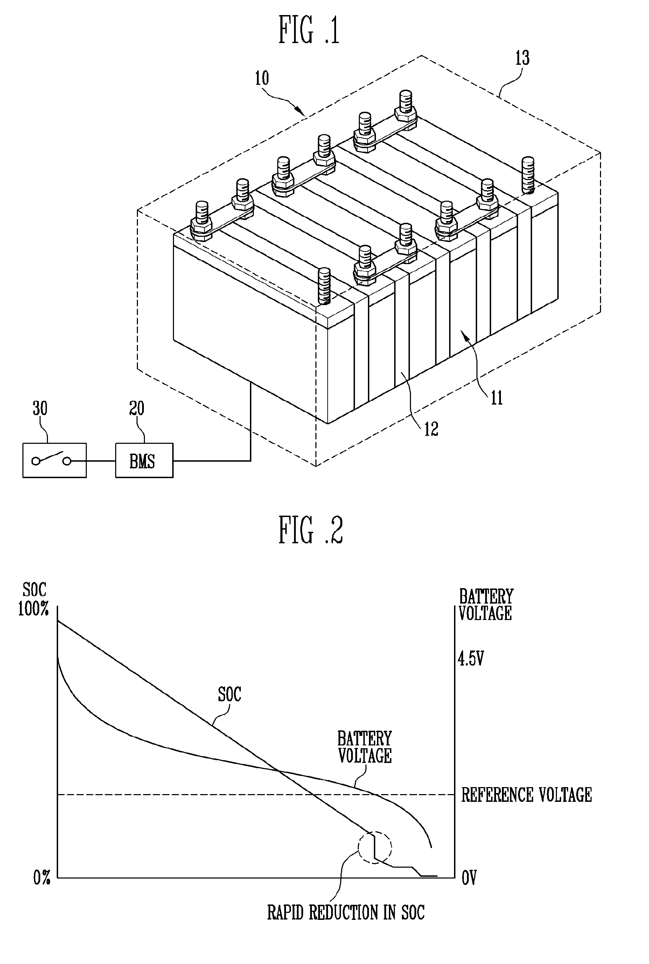

FIG. 1 is a view illustrating a battery according to one embodiment of the invention.

Referring to FIG. 1, a battery 10 suitable for use as a large capacity battery module includes a plurality of secondary batteries 11 continuously arranged at substantially uniform intervals, a housing 13 in which the secondary batteries are arranged and a cooling medium circulates, and a battery management system (BMS) 20 configured to manage charge and discharge of the battery.

Battery barriers 12 are arranged between neighboring secondary batteries 11 and in the outermost secondary batteries 11. The battery barriers 12 can maintain a substantially uniform distance between the secondary batteries 11, can circulate air to control the temperature, and can support the side surfaces of the secondary batteries 11.

In FIG. 1, the secondary batteries 11 have a substantially cuboid shape. However, the secondary batteries 11 may be cylindrical or other polygonal shape.

The BMS 20 detects current and voltage values of the secondary batteries 11 in the battery 10 and manages the detected current and voltage values.

The BMS 20 receives data from a current sensor and a voltage sensor provided in the battery 10. The BMS 20 stores data previously obtained by table mapping a relationship between an open circuit voltage (hereinafter, referred to as OCV) of the battery 10 and a state of charge (SOC) and estimates the SOC from measurement values obtained by the sensors. The BMS 20 calculates the initial SOC of the battery 10, integrates a charge current value and a discharge current value measured from charge and discharge start point in times with respect to time to calculate a current integration value, and adds the current integration value to the initial SOC to estimate an actual SOC.

However, the current of the battery 10 can be measured by the current sensor and an error may be generated in the measured value in accordance with performance of the current sensor. Therefore, when the battery 10 is driven for a long time, in particular, when the battery 10 has not been completely charged and/or discharged, a significant amount of error can accumulate in the current integration value. The accumulated error can deteriorate correctness of estimation of the SOC.

In order to prevent generation of the error, the SOC is generally compensated for so that the SOC is rapidly increased or reduced at a compensation point in time when a battery voltage reaches a previously set value during discharge.

FIG. 2 is a view illustrating an example of a case in which an SOC is rapidly reduced by compensation during estimating the SOC by current integration.

Referring to FIG. 2, when a battery voltage reaches a reference voltage, the SOC is compensated for so that the SOC is rapidly reduced by such compensation. Due to the rapid reduction in the SOC, the battery capacity that can be transmitted to a user is rapidly reduced.

In some embodiments, when the battery voltage reaches the reference voltage or when the estimated SOC reaches a reference SOC, the BMS 20 estimates the SOC of the battery by an SOC estimating model instead of compensating for the SOC value.

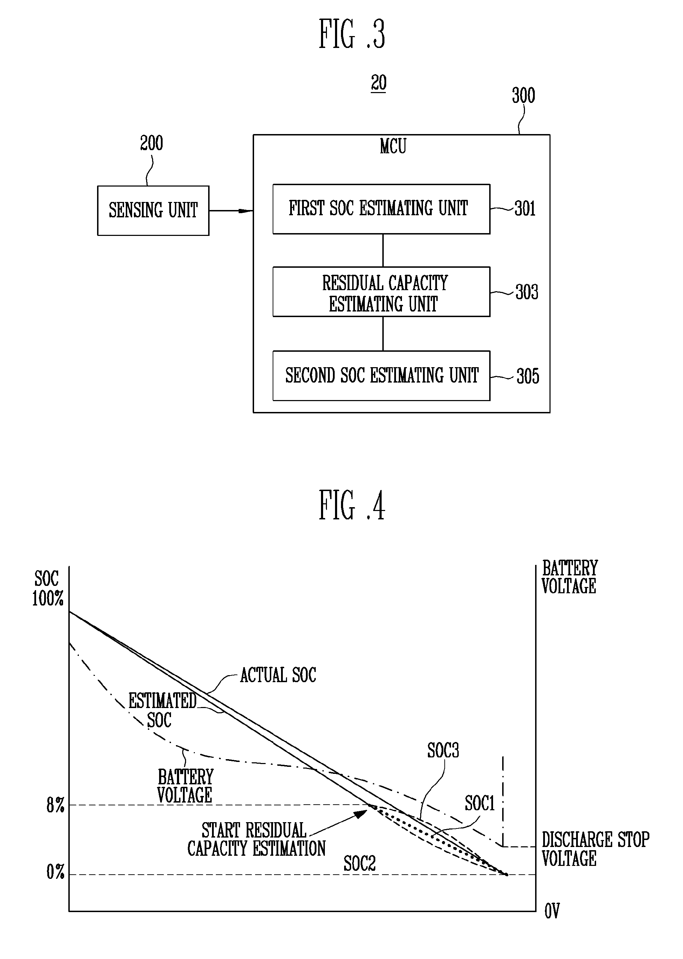

FIG. 3 is a block diagram schematically illustrating a battery management system (BMS).

As illustrated in FIG. 3, the BMS 20 may include a sensing unit (or a sensor) 200 and a main controller unit (MCU) 300.

The sensing unit 200 measures at least one of: charge and discharge current of a battery, a voltage of a battery, and a temperature of a battery using a current sensor, a voltage sensor, and a temperature sensor to transmit the measured battery charge and discharge current, battery voltage, and battery temperature to the MCU 300.

The MCU 300 may include a first SOC estimating unit (or a first SOC estimator) 301, a residual capacity estimating unit 303, and a second SOC estimating unit (or a second SOC estimator) 305.

In some embodiments, the first SOC estimating unit 301 estimates the SOC of the battery using at least one of the battery charge and discharge current, the battery voltage, and the battery temperature input from the sensing unit.

The first SOC estimating unit 301 may estimate the SOC using the OCV that is the battery voltage measured at a point time when the battery is stabilized or may estimate the SOC using the initial SOC and the current integration value and may estimate the SOC using various conventional methods of estimating the SOC.

The residual capacity estimating unit 303 may estimate a current residual capacity in which the estimated SOC is not rapidly reduced using at least one of a reference residual capacity calculated using the reference SOC, a currently measured battery voltage, a first reference voltage, and a second reference voltage when the SOC estimated by the first SOC estimating unit 301 is substantially equal to or less than the reference SOC.

In some embodiments, the reference SOC relates to an operation point in time when the residual capacity estimating unit 303 estimates the residual capacity may mean the SOC at the end of discharge.

The reference SOC may have a value between about 5% and about 8%. However, it will be apparent to those skilled in the art that various reference SOCs may be set up in accordance with a capacity of a battery, a kind of a device that uses a battery, and a use environment.

Here, the relationship between the residual capacity of the battery and the SOC may be expressed by EQUATION 1.

### EQUATION 1

$$SOC[\%] = \frac{RM}{Q_{max}} \times 100$$

wherein, RM means the residual capacity of the battery and $Q_{max}$ means an entire capacity of the battery.

Therefore, the residual capacity estimating unit 303 may calculate the reference residual capacity using the EQUATION 1 and the reference SOC.

The first reference voltage means a discharge stop voltage of the battery. In order to drive a device that uses the battery, a maximum desirable voltage exists. In some embodiments, when an output voltage of the battery is reduced to be substantially equal to or less than the minimum desirable voltage, the device may not be driven. That is, the discharge stop voltage of the battery means the minimum voltage for driving the device. When the voltage of the battery reaches the discharge stop voltage, although the battery may still have additional capacity, the residual capacity is considered to be about 0.

The second reference voltage means a battery voltage measured at a point in time when the SOC estimated by the SOC estimating unit 301 and the reference SOC are substantially the same.

According to an embodiment of the invention, the residual capacity estimating unit 303 may estimate a current first residual capacity substantially proportional to a value obtained by dividing the difference between the current battery voltage measured by the sensing unit 200 and the first reference voltage by a first proportional constant. At this time, the first proportional constant may be substantially proportional to a value obtained by dividing a difference between the second reference voltage and the first reference voltage by the reference residual capacity and the above relationship may be expressed by EQUATION 2.

## EQUATION 2

$$RM_1 = \frac{V_{cell} - V_{term}}{a_1}$$

$$a_1 = \frac{V_0 - V_{term}}{RM_0}$$

wherein, $RM_1$ means a first residual capacity, $V_{cell}$ means a current battery voltage, $V_{term}$ means a first reference voltage, $V_0$ means a second reference voltage, $RM_0$ means a reference residual capacity, and $a_1$ means a first proportional constant.

According to the EQUATION 2, when the current battery voltage is reduced, the first residual capacity is linearly reduced.

The residual capacity estimating unit 303 may estimate a current second residual capacity substantially proportional to an exponential function of a value obtained by dividing a difference between the current battery voltage measured by the sensing unit 200 and the first reference voltage by a second proportional constant. At this time, the second proportional constant may be substantially proportional to a value obtained by dividing the difference between the second reference voltage and the first reference voltage by a natural logarithm of the reference residual capacity and the above relationship may be expressed by EQUATION 3.

## EQUATION 3

$$RM_2 = e^{\frac{V_{cell} - V_{term}}{a_2}}$$

$$a_1 = \frac{V_0 - V_{term}}{In(RM_0)}$$

wherein, $RM_2$ means a second residual capacity and $a_2$ means a second proportional constant.

According to the EQUATION 3, when the current battery voltage is reduced, the second residual capacity is reduced in the form of an exponential function.

The residual capacity estimating unit 303 may estimate a current third residual capacity proportional to an exponential function of a value obtained by dividing a square root of the difference between the current battery voltage measured by the sensing unit 200 and the first reference voltage by a third proportional constant. At this time, the third proportional constant may be substantially proportional to a value obtained by dividing a square root of the difference between the second reference voltage and the first reference voltage by a natural logarithm of the reference residual capacity and the above relationship may be expressed by EQUATION 4.

## EQUATION 4

$$RM_3 = e^{\frac{\sqrt{V_{cell} - V_{term}}}{a_3}}$$

$$a_3 = \frac{\sqrt{V_0 - V_{term}}}{In(RM_0)}$$

wherein, $RM_3$ means a third residual capacity and $a_3$ means a third proportional constant.

According to the EQUATION 4, when the current battery voltage is reduced, the third residual capacity is reduced in the form of an exponential function. The third residual capacity is more slowly reduced than the second residual capacity due to the form of the square root.

The second SOC estimating unit 305 estimates a current SOC using one of the first to third residual capacities measured by the residual capacity estimating unit 303 and the EQUATION 1.

FIG. 4 is a graph illustrating an actual battery voltage and a result of estimating an SOC when a temperature around a battery is no less than, or above, 0°C.

Referring to FIG. 4, when the SOC is more than 8%, the SOC is estimated by the first SOC estimating unit 301 and, when the SOC is substantially equal to or less than about 8%, the SOC is estimated by the second SOC estimating unit 305. A graph in accordance with SOC1 illustrates the SOC estimated using the first residual capacity, a graph in accordance with SOC2 illustrates the SOC estimated using the second residual capacity, and a graph in accordance with SOC3 illustrates the SOC estimated using the third residual capacity.

As illustrated in FIG. 4, it is noted that, when the temperature around the battery is no less than about 0°C, a change in an actual SOC may be similar to a change in the SOC3 graph estimated using the third residual capacity.

Therefore, the second SOC estimating unit 305 may estimate the current SOC using the third residual capacity of the EQUATION 4 and the EQUATION 1 when the battery temperature is no less than 0°C.

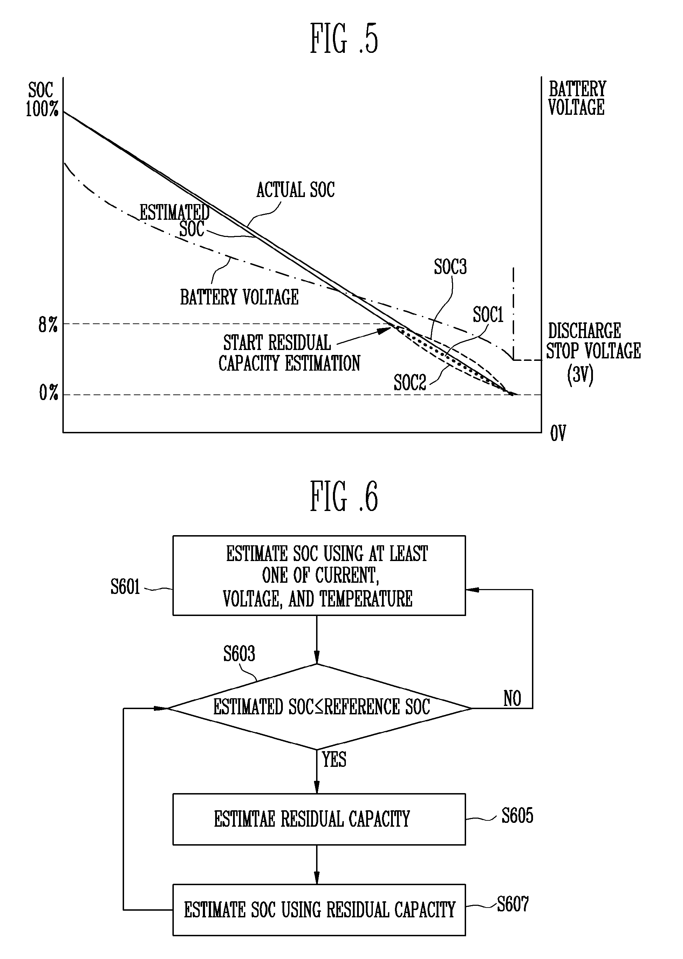

FIG. 5 is a graph illustrating an actual battery voltage and a result of estimating a residual capacity when a temperature around a battery is less than about 0°C.

In some embodiments, as shown in FIG. 5, when the SOC is more than about 8%, the SOC can be estimated by the first SOC estimating unit 301 and, when the SOC is substantially equal to or less than about 8%, the SOC is estimated by the second SOC estimating unit 305. FIG. 5 illustrates a graph where the SOC is estimated using the first residual capacity in reference to SOC1. FIG. 5 further illustrates, a graph where the SOC is estimated using the second residual capacity in reference to SOC2. FIG. 5 also illustrates a graph where the SOC estimated using the third residual capacity in regards to SOC3.

As illustrated in FIG. 5, it is noted that, when the temperature around the battery is less than about 0°C, a change in an actual SOC can be similar to a change in the SOC1 graph estimated using the first residual capacity.

Therefore, the second SOC estimating unit 305 may estimate the current SOC using the first residual capacity of the EQUATION 2 and the EQUATION 1 when the battery temperature is less than about 0°C.

In addition, referring to FIGS. 4 and 5, when the SOC can be estimated, the SOC usually is not rapidly reduced at the end of discharge.

In some embodiments, the residual capacity estimating unit 303 estimates the residual capacity when the SOC estimated by the first SOC estimating unit 301 is substantially the same as the reference SOC. However, the residual capacity estimating unit 303 may recognize a state of the battery as at the end of discharge to estimate the residual capacity when the measured battery voltage is substantially equal to or less than the reference voltage. In this case, the reference SOC may be the SOC measured when the battery voltage is the same as the reference voltage.

At this time, the reference voltage may be determined using a previously set voltage, current charge and discharge current measured by the sensing unit 200, and internal resistance of the battery. For example, the reference voltage may be expressed by EQUATION 5.

## EQUATION 5

$$V_0 = 3.52 - \frac{IR}{2}$$

wherein, $V_0$ means a reference voltage, 3.52 means a previously set voltage, I means charge and discharge current of a battery, and R means internal resistance of a battery.

In the EQUATION 5, for convenience sake, the previously set voltage is expressed as 3.52V. However, the previously set voltage is not limited to the above but may vary with a battery capacity, an environment of a battery, and a device connected to a battery.

FIG. 6 is a flowchart illustrating a method of driving a BMS according to an embodiment of the invention.

The first SOC estimating unit 301 estimates the SOC using at least one of the charge and discharge current, the voltage, and the temperature obtained by the sensing unit 200 S601.

Then, the MCU 300 determines whether the estimated SOC is substantially equal to or less than the reference SOC S603.

When the estimated SOC is substantially equal to or less than the reference SOC, the residual capacity estimating unit 303 estimates the current residual capacity using at least one of the reference residual capacity calculated using the reference SOC and the current battery voltage, the first reference voltage, and the second reference voltage measured by the sensing unit 200 S605.

At this time, the reference SOC may be between about 5% and about 8%. In addition, the first reference voltage may mean the discharge stop voltage of the battery and the second reference voltage may mean the battery voltage measured at the point in time when the estimated SOC is the same as the reference SOC.

Finally, the second SOC estimating unit 305 estimates the current SOC using the estimated current residual capacity S607.

Example embodiments of the invention have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the described technology as set forth in the following claims.

**Claims**

1.　A battery management system (BMS), comprising:

a first state of change (SOC) estimator configured to estimate an SOC of a battery with the use of at least one of i) a charge and discharge current of a battery, ii) a voltage of the battery and iii) a temperature of the battery;
a residual capacity estimator, when the estimated SOC is substantially equal to or less than the reference SOC, configured to estimate a current residual capacity with the use of at least one of i) a reference residual capacity calculated from a reference SOC, ii) the measured battery voltage, iii) a first reference voltage, and iv) a second reference voltage; and
a second SOC estimator configured to estimate a current SOC based at least in part on the current residual capacity.

**2.** A BMS as claimed in claim 1, wherein the reference SOC is from 5% to 8%.

**3.** A BMS as claimed in claim 1 or 2,
wherein the first reference voltage is a discharge stop voltage of the battery, and
wherein the second reference voltage is a voltage of the battery measured at a point in time when the estimated SOC and the reference SOC are substantially the same.

**4.** A BMS as claimed in claim 3,
wherein the residual capacity estimator is further configured to estimate a current first residual capacity substantially proportional to a value obtained by dividing the difference between the measured battery voltage and the first reference voltage by a first proportional constant, and
wherein the first proportional constant is substantially proportional to a value obtained by dividing the difference between the second reference voltage and the first reference voltage by the reference residual capacity.

**5.** A BMS as claimed in claim 3 or 4,
wherein the residual capacity estimator is further configured to estimate a current second residual capacity substantially proportional to an exponential function of a value obtained by dividing the difference between the measured battery voltage and the first reference voltage by a second proportional constant, and
wherein the second proportional constant is substantially proportional to a value obtained by dividing the difference between the second reference voltage and the first reference voltage by a natural logarithm of the reference residual capacity.

**6.** A BMS as claimed in claim 3, 4 or 5
wherein the residual capacity estimator is further configured to estimate a current third residual capacity substantially proportional to an exponential function of a value obtained by dividing the difference between the measured battery voltage and the first reference voltage by a third proportional constant, and
wherein the third proportional constant is substantially proportional to a value obtained by dividing the difference between the second reference voltage and the first reference voltage by a natural logarithm of the reference residual capacity.

**7.** A BMS as claimed in claim 4, 5or 6 wherein the second SOC estimator is further configured to estimate the current SOC based at least in part on the first residual capacity when the battery temperature is less than 0°C.

**8.** A BMS as claimed in claim 6 or 7, wherein the second SOC estimator is further configured to estimate the current SOC based at least in part on the third residual capacity when the battery temperature is no less than 0°C.

**9.** A BMS as claimed in any preceding claim, wherein, when the measured battery voltage is substantially equal to or less than a reference voltage, the residual capacity calculator is configured to i) set up the estimated SOC when the measured battery voltage is substantially the same as the reference voltage as the reference SOC and ii) estimate the current residual capacity.

**10.** A BMS as claimed in claim 9, wherein the reference voltage is configured to be determined based at least in part on a previously set voltage, the measured charge and discharge current, and internal resistance of the battery.

**11.** A method of driving a battery management system (BMS), comprising:

estimating an SOC of a battery based on at least one of a charge and discharge current of the battery, a voltage of the battery, and a temperature of the battery;
estimating, when the estimated SOC is substantially equal to or less than the reference SOC, a current residual capacity based on at least one of a reference residual capacity calculated using a reference SOC, the measured battery voltage, a first reference voltage, and a second reference voltage; and
estimating a current SOC based at least partially on the current residual capacity.

**12.** A method as claimed in claim 11, wherein the reference SOC is from 5% to 8%.

**13.** A method as claimed in claim 11 or 12,
wherein the first reference voltage is a discharge stop voltage of the battery, and
wherein the second reference voltage is a voltage of the battery measured at a point in time when the estimated SOC and the reference SOC are substantially the same.

**14.** A BMS as claimed in any preceding claim, further comprising a sensor configured to measure at least one of: i) the charge and discharge current of the battery, ii) the voltage of the battery and iii) the temperature of the battery.

**15.** A BMS as claimed in any preceding claim, wherein the first and second SOC estimators and the residual capacity estimator are included in a controller.

## FIG .1

## FIG .2

# FIG .3

## 20

### 300

MCU

200

SENSING UNIT →

FIRST SOC ESTIMATING UNIT —301

RESIDUAL CAPACITY
ESTIMATING UNIT —303

SECOND SOC ESTIMATING UNIT —305

# FIG .4

SOC
100%

BATTERY
VOLTAGE

ACTUAL SOC

ESTIMATED
SOC

SOC3

BATTERY
VOLTAGE

8%

SOC1

START RESIDUAL
CAPACITY ESTIMATION

DISCHARGE STOP
VOLTAGE

SOC2

0%

0V

EP 2 808 690 A1

## FIG .5

## FIG .6

10

Europäisches
Patentamt

European
Patent Office

Office européen
des brevets

# EUROPEAN SEARCH REPORT

Application Number

EP 14 17 0121

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2010/070220 A1 (DARILEK CHRISTOPHER [US]) 18 March 2010 (2010-03-18) * paragraphs [0011], [0012], [0026] - [0054]; claims 1-9; figures 1,3 * | 1-15 | INV. G01R31/36 |
| A | FR 2 739 452 A1 (RENAULT [FR]) 4 April 1997 (1997-04-04) * abstract; figures 1-3 * * page 2, line 25 - page 4, line 10 * * page 7, line 9 - page 11, line 3 * | 1-15 | |
| A | KR 2003 0038992 A (HYUN DAI HEAVY IND CO LTD [KR]) 17 May 2003 (2003-05-17) * the whole document * | 1-15 | |
| A | US 2008/091363 A1 (LIM GYE-JONG [KR] ET AL) 17 April 2008 (2008-04-17) * abstract; figures 2,3a,3b * | 1-15 | |
| A | JP 2009 171789 A (FUJITSU TEN LTD) 30 July 2009 (2009-07-30) * the whole document * | 1-15 | TECHNICAL FIELDS SEARCHED (IPC) |
| A | US 6 127 806 A (TANJO YUJI [JP] ET AL) 3 October 2000 (2000-10-03) * abstract; figures 2,5-7 * * column 1, line 15 - column 1, line 46 * * column 2, line 59 - column 3, line 34 * * column 4, line 1 - column 5, line 32 * | 1-15 | G01R |

The present search report has been drawn up for all claims

| Place of search | Date of completion of the search | Examiner |
|---|---|---|
| Munich | 29 October 2014 | Maric, Viktor |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**ANNEX TO THE EUROPEAN SEARCH REPORT
ON EUROPEAN PATENT APPLICATION NO.**

EP 14 17 0121

This annex lists the patent family members relating to the patent documents cited in the above-mentioned European search report.
The members are as contained in the European Patent Office EDP file on
The European Patent Office is in no way liable for these particulars which are merely given for the purpose of information.

29-10-2014

| Patent document cited in search report | Publication date | Patent family member(s) | Publication date |
|---|---|---|---|
| US 2010070220 A1 | 18-03-2010 | CA 2646169 A1 | 18-10-2007 |
| | | CA 2744155 A1 | 18-10-2007 |
| | | CN 101411034 A | 15-04-2009 |
| | | CN 102931700 A | 13-02-2013 |
| | | EP 2002525 A2 | 17-12-2008 |
| | | JP 2009532678 A | 10-09-2009 |
| | | JP 2013057673 A | 28-03-2013 |
| | | KR 20080105141 A | 03-12-2008 |
| | | KR 20140041936 A | 04-04-2014 |
| | | US 2007236183 A1 | 11-10-2007 |
| | | US 2010070220 A1 | 18-03-2010 |
| | | WO 2007117986 A2 | 18-10-2007 |
| FR 2739452 A1 | 04-04-1997 | NONE | |
| KR 20030038992 A | 17-05-2003 | NONE | |
| US 2008091363 A1 | 17-04-2008 | KR 20080033628 A | 17-04-2008 |
| | | US 2008091363 A1 | 17-04-2008 |
| JP 2009171789 A | 30-07-2009 | NONE | |
| US 6127806 A | 03-10-2000 | JP 3716619 B2 | 16-11-2005 |
| | | JP H11326472 A | 26-11-1999 |
| | | US 6127806 A | 03-10-2000 |

EPO FORM P0459

For more details about this annex : see Official Journal of the European Patent Office, No. 12/82